Europäisches Patentamt

European Patent Office

Office européen des brevets

(11) Veröffentlichungsnummer: **0 377 063**
**A1**

## (12) EUROPÄISCHE PATENTANMELDUNG

(21) Anmeldenummer: **89100097.8**

(22) Anmeldetag: **04.01.89**

(51) Int. Cl.⁵: **H01R 9/07**

(43) Veröffentlichungstag der Anmeldung:
**11.07.90 Patentblatt 90/28**

(84) Benannte Vertragsstaaten:
**CH DE ES FR GB IT LI NL SE**

(71) Anmelder: **Siemens Aktiengesellschaft**
**Wittelsbacherplatz 2**
**D-8000 München 2(DE)**

(72) Erfinder: **Kinzler, Hans, Dipl.-Ing. (FH)**
**Roter Brachweg 69**
**D-8400 Regensburg(DE)**
Erfinder: **Dirmeyer, Josef, Dipl.-Ing. (FH)**
**Neuenschwand 64**
**D-8465 Bodenwöhr(DE)**

(54) **Anordnung, z.B. für LCD-Steuerung in einem Kfz-Bordcomputer, zum elektrischen Verbinden der Anschlussflecken zweier Platten mit einer Leitungsträgerfolie.**

(57) Anordnung, z.B. für langzeitstabil zuverlässige, schüttelfeste LCD-Steuerung in einem Kfz-Bordcomputer, zur elektrisch leitenden Verbindung (Z) zwischen vielen, z.B. 20 oder 200 verschiedenen, Anschlußflecken (A) einer ersten Platte (L), z.B. einer Leiterplatte oder einer LCD-Scheibe (L), einerseits und individuell zugeordneten, gleichvielen Anschlußflecken (A) einer zweiten Platte (P), z.B. einer mit Elektronik bestückten Leiterplatte (P) andererseits, wobei

- die vielen Anschlußflecken (A) beider Platten (L, P) jeweils in einer langen Reihe dicht nebeneinander (z.B. längs der Kanten K) auf der betreffenden Platte (L, P) angebracht sind,
- eine flexible Leitungsträgerfolie (F) mindestens gleichviele (im allgemeinen kreuzungsfrei) nebeneinander schichtförmig angebrachte Zwischenleitungen (Z) trägt, welche (Z) jeweils die Verbindung zwischen den Anschlußflecken (A) der ersten Platte (L) und den individuell zugeordneten Anschlußflecken (A) der zweiten Platte (P) herstellt,
- jede Zwischenleitung (Z), zumindest vor dem Verbinden der Anschlußflecken (A), in jenen beiden Abschnitten (B) in welchen sie jeweils mit Anschlußflecken (A) der Platten (L, P) zu verbinden sind, einen durch Wärme verklebbaren, zusätzlich mit Metallkörpern als Leitermaterial ausgestatteten Klebstoff (B) enthält, der (B) seinerseits beim Herstellen der Verbindungen ("versiegeln") erwärmt und an den betreffenden Anschlußflecken (A) mehr oder weniger angedrückt wird, und
- ein oder mehrere elastische Körper (S) durch eine oder mehrere Halterungen (H) auf die Leitungsträgerfolie (F) zumindest im Bereich (B) der bereits versiegelten Verbindungen (A, B) mit den Anschlußflecken (A) gedrückt sind.

FIG 3

## Anordnung, z.B. für LCD-steuerung in einem Kfz-Bordcomputer, zum elektrischen Verbinden der Anschlußflecken zweier Platten mit einer Leitungsträgerfolie

Die Erfindung wurde zwar zunächst für einen Bordcomputer eines Kfz mit LCD-Anzeigeeinheit entwickelt, wobei auf einer Leiterplatte angebrachte, computergesteuerte Verstärker die LCD-Elemente auf einer LCD-Glasscheibe steuern. Es stellte sich jedoch heraus, daß die Erfindung nicht darauf beschränkt ist, sondern ganz allgemein für sogenannte versiegelte Verbindungen zwischen Anschlußflecken von Platten mittels Leitungsträgerfolien besondere Bedeutung hat.

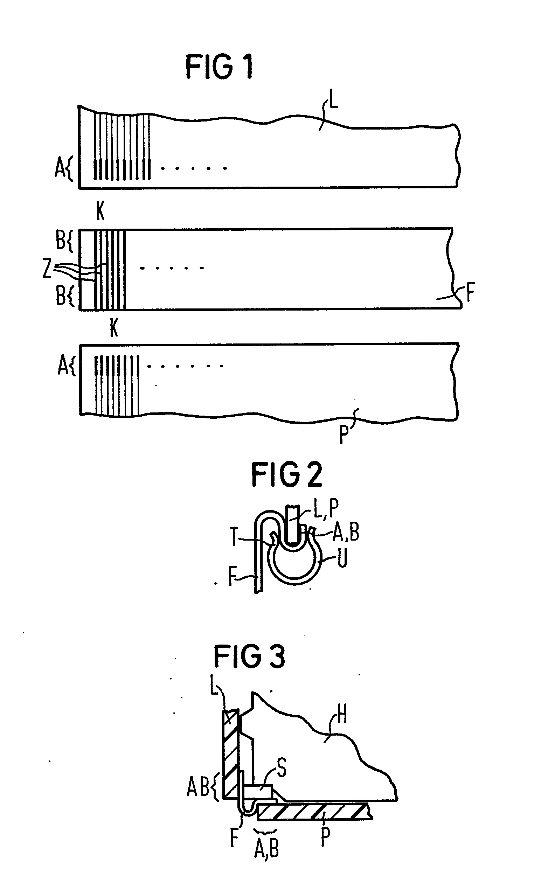

Die Erfindung geht von der im Oberbegriff des Patentanspruches 1 definierten bekannten Anordnung aus. Beispiele dieser bekannten Anordnung zeigen die Explosionsdarstellung in Figur 1 vor dem Verbinden und in Figur 2 nach dem Verbinden durch Versiegeln. Derartige flexible Leitungsträgerfolien werden auf dem Markt z.B. durch Nippon Graphite Industries unter den Bezeichnungen HSC (Heat Seal Connector) und A-HSC (Anisotropic-HSC) angeboten. Die Leitungsträgerfolie F trägt also Serien von Zwischenleitungen Z, die an ihren Abschnitten B, hier längs der Kanten K, mit den Anschlußflecken A der beiden Leiterplatten L, P verbunden werden. Dazu werden die Platten L, P präzis gegeneinander positioniert, die Leitungsträgerfolie F so darübergelegt, daß die eine Kleb- bzw. Siegelmasse enthaltenden Zwischenleitungsabschnitte B deckungsgleich über den zu verbindenden Anschlußflecken A liegen. Die betreffende Kleb- bzw. Siegelmasse enthält also - trotz des Wortes "Siegel" - evtl. keine übliche Siegelmasse für Urkundensiegel, also evtl. auch keinen Siegellack. Es kann sich hier vielmehr auch um eine Gruppe von Stoffen handeln, die unter den Begriff "Schmelzkleber" fallen. Hierbei wird die Leitungsträgerfolie F im Bereich ihrer Abschnitte B mit elastischen Körpern auf die Leiterplatten L, P gedrückt, z.B. mit 20 kg/cm², und dann ausreichend lange ausreichend stark erwärmt, z.B. für drei Sekunden auf 130° C. Dann sind die leitenden Verbindungen zwischen den Anschlußflecken A beider Platten L, P über die Zwischenleitungen Z hergestellt.

Diese Methode zum elektrischen Verbinden durch Versiegeln ist nicht nur besonders unkompliziert, sondern auch ziemlich zuverlässig und sehr preiswert, besonders wenn die miteinander zu verbindenden Anschlußflecken A jeweils längs Kanten K der Platten L, P angeordnet sind. Eine derartige Anordnung ist also besonders für Massenfertigungen geeignet, besonders auch dann, wenn eine der beiden Platten oder beide Platten L, P sehr wärmeempfindlich sind, also z.B. Glasscheiben mit LCD-Schichten sind. Der Hersteller solcher versiegelbaren Leitungsträgerfolien F empfiehlt daher diese Folien F auch besonders für LCD-Anzeigeeinheiten, besonders auch für farbige LCD's, unter anderem auch für die Verwendung in einem Kfz.

Im allgemeinen bleibt eine gewisse Restschwierigkeit bei solchen versiegelten Verbindungen. Eigentlich sollen sie ja im allgemeinen möglichst langzeitstabil zuverlässige Verbindungen bieten. Einzelne der vielen versiegelten Verbindungen neigen aber mit der Zeit dazu, sich zu lösen. Nicht nur Luftfeuchtigkeit, Schadstoffe in der Luft und Oxidation können schädlich sein, sondern vor allem auch mechanische Vibrationen und Stöße.

Zur Erhöhung der Zuverlässigkeit der Verbindungen sich daher schon bisher Zusatzmaßnahmen üblich. Z.B. werden zusätzlich die Überlappungen zwischen der Leitungsträgerfolie F mit den Platten L, P durch zusätzliche Klebstoffe miteinander zusätzlich verklebt. Es ist auch üblich, gemäß Figur 2 lange Metallschienen U, welche lange Reihen von Federzungen T enthalten, über die Kanten K der Platten L, P so zu schieben, daß die Leitungsträgerfolie F auf die versiegelten Verbindungen der Anschlußflecken A mit den Abschnitten B langzeitstabil zuverlässig angedrückt wird. Auch andere Formen von solchen Metallschienen U zum nachträglichen Andrücken der Leitungsträgerfolie F auf die versiegelten Verbindungen A, B durch federnde Elemente sind erprobt. Alle diese Zusatzmaßnahmen, wie Kleben und Metallschienen, sind aber für die Serienfertigung solcher Anordnungen nicht recht befriedigend. Vor allem Verklebungen sind in Serienfertigungen nur sehr schwierig sauber genug durchzuführen und setzen außerdem oft vorherige, entsprechende, heikle Reinigungen im Bereich der Plattenkanten K voraus.

Die Erfindung löst die Aufgabe,
eine für Serienfertigung geeignete Zusatzmaßnahme zu bieten,
welche versiegelte Verbindungen langzeitstabil zuverlässig,
selbst gegen Stöße und Vibrationen weitgehend unempfindlich macht,
durch die im Patentanspruch 1 angegebenen Maßnahmen.

Die Erfindung verbessert also das nachträgliche Andrücken der Leitungsträgerfolie auf die Verbindungen, ohne die Vorteile der Verbindung durch Versiegeln zu beeinträchtigen und ohne dazu in Serienfertigung schwer handhabbare Verklebungen oder Verklammerungen durch mehr oder weniger federnde Metallschienen bzw. Klammern zu benötigen.

Die in den Unteransprüchen genannten zusätzlichen Maßnahmen gestatten, zusätzliche Vorteile zu erreichen. Unter anderem gestatten die Maßnahmen gemäß Patentanspruch

2, auf besonders elegante Weise Raum und Material zu sparen; -eine Weiterbildung, die sich überdies besonders in solchen Fällen bewährt, bei denen die beiden elektrisch zu verbindenden Platten ohnehin aus anderen Gründen bei der endgültigen Verwendung in einem Gerät in der betreffenden Weise abgewinkelt werden sollen/können,

3, mit besonders wenig Aufwand einen besonders gut geeigneten elastischen Körper zu verwenden, der langzeitstabil seine wesentlichen Eigenschaften beibehält, wobei dieser elastische Körper besonders gleichmäßig auf die Leitungsträgerfolie und damit auf die Verbindungen zwischen den Anschlußflecken und den Zwischenleitungsabschnitten drückt,

4, besonders langzeitstabile zuverlässige Verbindungen zu ermöglichen, indem Ausdünstungen des elastischen Körpers, welche die Verbindungen beeinträchtigen können, langzeitstabil vermieden werden können,

5, eine besonders günstige Verwendung zu bieten, besonders wenn zusätzlich die Maßnahme gemäß Patentanspruch 2 getroffen wird, wobei die eine Platte eine LCD-Scheibe und die andere Platte eine Leiterplatte ist,

6, eine besonders günstige Anwendung auch unter besonders stark vibrationsgefährdeten Verhältnissen zu bieten, sowie

7, auch Anwendungen zu ermöglichen, auf denen es auf besonders große langzeitstabile Zuverlässigkeit der Verbindungen ankommt, obwohl in diesem Fall im allgemeinen besonders viele Anschlußflekken der einen Platte (im allgemeinen weit über 1000 Anschlußflecken) mit entsprechend vielen Anschlußflecken der anderen Platte langzeitstabil zuverlässig zu verbinden sind - also von Haus aus wegen der besonders hohen Anzahl von Anschlußflecken eine erhöhte Gefahr von Unterbrechungen der Verbindungen besteht.

Die Erfindung wird anhand von Figur 3 erläutert, welche ein besonders günstiges Ausführungsbeispiel der Erfindung zeigt.

Das erfindungsgemäße Beispiel entspricht in vielen Aspekten dem bekannten, anhand von Figur 1 und 2 gezeigten Beispiel:

Auch bei der Erfindung werden elektrisch leitende Verbindungen zwischen vielen, z.B. 20 oder 200 oder einigen Tausend verschiedenen, Anschlußflecken A der ersten Platte L einerseits und den individuell zugeordneten, gleichvielen Anschlußflecken A der zweiten Platte P andererseits mittels der flexiblen ansiegelbaren Leitungsträgerfolie F hergestellt. Die Anschlußflecken A beider Platten L, P sind jeweils wie bei dem vorbekannten Beispielen in einer langen Reihe dicht nebeneinander auf den betreffenden Platten L, P angebracht, und zwar in dem gezeigten Fall längs der Kanten K dieser Platten L, P.

Die Leitungsträgerfolie F weist bei der Erfindung wie beim Stand der Technik mindestens gleichviele - im allgemeinen kreuzungsfrei - nebeneinander schichtförmig angebrachte Zwischenleitungen Z auf, welche ihrerseits jeweils die leitende Verbindung zwischen den Anschlußflecken A der ersten Platte L und den zugeordneten Anschlußflecken A der zweiten Platte P herstellen. Bei der Erfindung und bei den bekannten Beispielen sind auf der Leitungsträgerfolie F diese Zwischenleitungen Z, zumindest vor dem Herstellen der Verbindungen/Versiegelungen, entweder auf ihrer ganzen Länge mittels Kleb- bzw. Siegelmasse hergestellt, oder zumindest in jenen beiden Abschnitten B, an welchen diese Zwischenleitungen Z jeweils mit den deckungsgleich angeordneten Anschlußflecken A der Platten L, P zu verbinden sind. Die Kleb-bzw. Siegelmasse enthält dabei jeweils einen durch Wärme klebbaren (z.B. schmelzbaren), bereits in irgendeiner Weise mit Metallkörpern als Leitermaterial ausgestatteten Klebstoff, der seinerseits zum Versiegeln der Verbindungen A/B erwärmt und an den betreffenden Anschlußflecken A mehr oder weniger angedrückt wird. Sowohl der Aufbau der Platten L, P und der Leitungsträgerfolie F einschließlich der Siegelmasse als auch das Verfahren durch Erwärmen und Andrücken können also bei der Erfindung und bei dem Stand der Technik an sich identisch sein. Dabei kann auch bei der Erfindung z.B. eine Leitungsträgerfolie F verwendet werden, wie sie von Nippon Graphite Industries angeboten wird.

Abweichend vom Stand der Technik ist jedoch die zusätzliche erfindungsgemäße Maßnahme, welche die Vibrationsempfindlichkeit, Stoßempfindlichkeit und sonstigen Grunde für Langzeit-Unzuverlässigkeit der versiegelten Verbindungsstellen A/B beseitigen soll. Statt Verklebungen und statt der in Figur 2 gezeigten Verklammerung mit speziellen Metallschienen bzw. Federgebilden, ist bei der Erfindung als zusätzliche Maßnahme zur Beseitigung solcher Störungen vorgesehen, ein - oder mehrere - elastische Körper S durch eine - oder mehrere - Halterungen H so auf die Leitungsträgerfolie F im Bereich der bereits versiegelten Verbindungen A/B zu drücken, daß selbst dann, wenn sich aus irgend welchen Gründen die Verbindungen A/B wieder lösen, die betreffenden Verbindungen durch den ständigen Druck des elastischen Körpers S aufrechterhaltenbleiben.

Die betreffende Halterung H kann hierbei ein Mehrzweck-Gegenstand sein, der seinerseits nicht nur in entsprechender Weise auf den elastischen Körper S drückt, sondern zusätzliche Funktionen ausübt. So kann diese Halterung H z.B. zusätzlich eine Reihe von Glühlampen oder lichtemittierenden Dioden enthalten, welche eine LCD-Glasscheibe L bestrahlen/durchstrahlen, wobei hier dann die erste Platte L eine LCD-Scheibe ist und die zweite Platte P eine mit Verstärkern und Mikroprozessoren bestückte Leiterplatte sein kann. Außerdem kann die Halterung H z.B. die zweite Platte P tragen, z.B. mittels Schrauben. Die Halterung H kann auch als Anschlag für eine nach links umklappbare LCD-Scheibe L/erste Platte L dienen, z.B. um besonders leicht defekte Glühlampen bzw. Dioden austauschen zu können. Besonders eine solche Anordnung mit LCD-Scheibe als erste Platte L und einer Mehrzweck-Halterung H, die zusätzlich lichtemittierende Bauelemente enthält, eignet sich daher auch als leicht reparierbare LCD-Anzeigeeinheit eines Kfz-Bordcomputers, oder auch als leicht reparierbare LCD-Anzeigeeinheit einer Werkzeugmaschine, oder als einer der leicht reparierbaren Hauptbestandteile eines LCD-Fernsehgerätes.

Die Erfindung läßt es im Prinzip zwar zusätzlich neben der Anbringung des elastischen Körpers S auch noch die bekannten Zusatzmaßnahmen Kleben und/oder Verklammern gemäß Figur 2 zu, um damit jene Langzeitstörungen der Verbindungen A/B zu beseitigen. Die Erfahrung zeigte jedoch, daß zumindest im allgemeinen die erfindungsgemäße Anbringung alleine des elastischen Körpers S ausreicht. Die Erfindung ist jedoch nicht auf diese alleinige Anbringung eines elastischen Körpers, vgl. S, beschränkt, sondern umfaßt auch Anordnungen, die neben einem solchen elastischen Körper noch zusätzlich Verklebungen und/oder Verklammerungen, vgl. Figur 2, enthalten.

Figur 3 zeigt auch eine spezielle weiterbildende Maßnahme der Erfindung: Die beiden Platten L, P sind, bezogen auf die Ebenen, in denen ihre Anschlußfleckenreihen A angebracht sind, gegeneinander abgewinkelt angeordnet, so daß die Leitungsträgerfolie F längs ihrer Zwischenleitungen Z stark verbogen ist. Der elastische Körper S und die Halterung H kann in diesem Fall besonders einfach aufgebaut sein, indem nämlich der elastische Körper S stabförmig ausgebildet sein kann und mit seiner ersten Seite auf die versiegelten Verbindungen A/B der ersten Platte L und gleichzeitig mit seiner abgewinkelten zweiten Seite auf die versiegelten Verbindungen A/B der zweiten Platte P drückt. Die Halterung H kann hier also so gestaltet werden, daß sie ihrerseits in etwa längs der Winkelhalbierenden zwischen den beiden Platten L, P auf den stabförmigen elastischen Körper S drückt. Eine solche Gestaltung der erfindungsgemäßen Anordnung ist nicht nur besonders massenproduktionsfreundlich, sondern auch besonders aufwandsarm hinsichtlich Material, oft auch hinsichtlich Platz.

Besonders vorteilhaft erwies sich Silikon-Schaumstoff als elastischer Körper S, und zwar besonders dann, wenn dieser Schaumstoff sehr kleinporig ist, nämlich Poren enthält, die im allgemeinen höchstens gleich dick wie - nach Möglichkeit kleiner als - die Dicke der Folie F sind. Zusätzlich erwies sich, daß es besonders vorteilhaft ist, wenn dieser Schaumstoff S geschlossenporig ist, zumindest an jenen Stellen seiner Oberfläche/Seiten, mit welcher/welchen dieser poröse Schaumstoff S auf die Leitungsträgerfolie F im Bereich der Verbindungen A/B gedrückt wird. Ein geschlossenporiger Schaumstoff S drückt besonders gleichmäßig auf die Verbindungen A/B, so daß selbst bei ungewöhnlich starken Vibrationen und relativ stark schädlichen Umwelteinflüssen die Verbindungen A/B mit besonderer Zuverlässigkeit aufrechterhalten bleiben.

Es zeigte sich zusätzlich, daß die langzeitstabile Zuverlässigkeit der Verbindungen A/B weiter dadurch erhöht werden kann, daß von vornherein weitgehend verhindert wird, daß der elastische Körper/Schaumstoff S nachträglich störende Ausdünstungen abgibt. Um solche Ausdünstungen - auch für lange Zeit - unschädlich zu machen, erwies sich als günstig, den elastischen Körper/Schaumstoff S vor der endgültigen Anbringung in der Anordnung, vgl. Figur 3, vorzutempern, und zwar bei einer Temperatur oberhalb der maximalen Betriebstemperatur der Anordnung. Wenn die maximale Betriebstemperatur der Anordnung bei + 85° C liegt, wurden bei Silikon-Schaumstoff S gute Erfahrungen gemacht, wenn dieser Schaumstoff S bei 150° C zwei Stunden lang vorgetempert wurde.

## Ansprüche

1. Anordnung, z.B. für langzeitstabil zuverlässige, schüttelfeste LCD-Steuerung in einem Kfz-Bordcomputer, zur elektrisch leitenden Verbindung (Z) zwischen vielen, z.B. 20 oder 200 verschiedenen, Anschlußflecken (A) einer ersten Platte (L), z.B. einer Leiterplatte oder einer LCD-Scheibe (L), einerseits und individuell zugeordneten, gleichvielen Anschlußflecken (A) einer zweiten Platte (P), z.B. einer mit Elektronik bestückten Leiterplatte (P) andererseits, wobei

- die vielen Anschlußflecken (A) beider Platten (L, P) jeweils in einer langen Reihe dicht nebeneinander (z.B. längs der Kanten K) auf der betreffenden Platte (L, P) angebracht sind,
- eine flexible Leitungsträgerfolie (F) mindestens gleichviele (im allgemeinen kreuzungsfrei) nebeneinander schichtförmig angebrachte Zwischenleitungen (Z) trägt, welche (Z) jeweils die Verbindung zwischen den Anschlußflecken (A) der ersten Platte (L) und den individuell zugeordneten Anschlußflecken (A) der zweiten Platte (P) herstellt, und

- jede Zwischenleitung (Z), zumindest vor dem Verbinden der Anschlußflecken (A), in jenen beiden Abschnitten (B) in welchen sie jeweils mit Anschlußflecken (A) der Platten (L, P) zu verbinden sind, einen durch Wärme verklebbaren, zusätzlich mit Metallkörpern als Leitermaterial ausgestatteten Klebstoff (B) enthält, der (B) seinerseits beim Herstellen der Verbindungen ("versiegeln") erwärmt und an den betreffenden Anschlußflecken (A) mehr oder weniger angedrückt wird,

**dadurch gekennzeichnet, daß**

- ein oder mehrere elastische Körper (S) durch eine oder mehrere Halterungen (H) auf die Leitungsträgerfolie (F) zumindest im Bereich (B) der bereits versiegelten Verbindungen (A, B) mit den Anschlußflecken (A) gedrückt sind.

2. Anordnung nach Patentanspruch 1,

**dadurch gekennzeichnet, daß**

- die beiden Platten (L, P) zumindest im Bereich ihrer Anschlußflecken-Reihen (A) gegeneinander so abgewinkelt ange ordnet sind, daß die Leitungsträgerfolie (F) längs ihrer Zwischenleitungen (Z) mehr oder weniger gebogen ist, und

- der elastische Körper (S) mit seiner (S) ersten Seite auf die versiegelten Verbindungen (A, B) der ersten Platte (L), und gleichzeitig mit seiner (S) abgewinkelten zweiten Seite auf die versiegelten Verbindungen (A, B) der zweiten Platte (P) gedrückt ist.

3. Anordnung nach Patentanspruch 1 oder 2,

**dadurch gekennzeichnet, daß**

- der elastische Körper (S) ein Schaumstoffkörper (S) ist,

-- welcher (S) im Vergleich zur Dicke der Leitungsträgerfolie (F) kleinporig ist, und

-- welcher zumindest an der Oberfläche, nämlich an seiner Seite / seinen Seiten, mit der/den er (S) auf die Leitungsträgerfolie (F) im Bereich (B) der Verbindungen (A, B) gedrückt ist, geschlossenporig ist.

4. Anordnung nach einem der vorhergehenden Patentansprüche,

**dadurch gekennzeichnet, daß**

- der elastische Körper (S), vor der endgültigen Anbringung in der Anordnung, bei einer Temperatur vorgetempert wurde, welche oberhalb der maximalen Betriebstemperatur der Anordnung liegt.

5. Anordnung nach einem der vorhergehenden Patentansprüche,

**dadurch gekennzeichnet, daß**

- sie in einer LCD-Anzeigeeinheit eines Kfz-Bordcomputers verwendet wird.

6. Anordnung nach einem der Patentansprüche 1 bis 4,

**dadurch gekennzeichnet, daß**

- sie in einer LCD-Anzeigeeinheit einer Werkzeugmaschine verwendet wird.

7. Anordnung nach einem der Patentansprüche 1 bis 4,

**dadurch gekennzeichnet, daß**

- sie in einem LCD-Fernsehgerät verwendet wird.

# FIG 1

A{

K

B{
Z
B{

K

A{

L

F

P

# FIG 2

T
F

L,P
A,B
U

# FIG 3

L

H

AB{

S

F

$\widetilde{A,B}$

P

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.3) |
|---|---|---|---|
| A | DE-A-3 313 080 (B.B.C.)<br>* Zusammenfassung; Seite 5, Zeile 31 - Seite 6, Zeile 8; Figur 5 *<br>--- | 1,3 | H 01 R 9/07 |
| A | DE-A-4 466 184 (GENERAL DYNAMICS)<br>* Zusammenfassung; Spalte 4, Zeilen 33-40; Figur 2 *<br>--- | 1 | |
| A | DE-A-3 109 250 (BOSCH-SIEMENS)<br>* Zusammenfassung; Seite 3, Zeilen 5-15 *<br>--- | 1 | |
| A | US-A-4 610 495 (ROGERS)<br>* Zusammenfassung; Spalte 4, Zeilen 3-57; Figur 1A *<br>--- | 1 | |
| A | GB-A- 954 223 (SANDERS)<br>* Seite 3, Zeilen 17-75 *<br>----- | 1 | |

**RECHERCHIERTE SACHGEBIETE (Int. Cl.3)**

H 01 R

Der vorliegende Recherchenbericht wurde für alle Patentansprüche erstellt

| Recherchenort | Abschlußdatum der Recherche | Prüfer |
|---|---|---|
| DEN HAAG | 18-05-1989 | HORAK A.L. |